(19) Europäisches Patentamt
European Patent Office
Office européen des brevets

(11) **EP 3 910 420 A1**

(12) **EUROPEAN PATENT APPLICATION**

(43) Date of publication:
**17.11.2021 Bulletin 2021/46**

(51) Int Cl.:
***G03F 7/20*** *(2006.01)*　　***G02B 27/28*** *(2006.01)*

(21) Application number: **20174769.8**

(22) Date of filing: **14.05.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **MUYS, Peter Frans Maria**
**5500 AH Veldhoven (NL)**

• **VAN ZWOL, Adriaan Roelof**
**5500 AH Veldhoven (NL)**
• **MATHEW, John Philip**
**5500 AH Veldhoven (NL)**
• **MULDER, Heine Melle**
**5500 AH Veldhoven (NL)**

(74) Representative: **ASML Netherlands B.V.**
**Corporate Intellectual Property**
**P.O. Box 324**
**5500 AH Veldhoven (NL)**

Remarks:
Claims 16 - 33 are deemed to be abandoned due to non-payment of the claims fees (Rule 45(3) EPC).

(54) **POLARIZATION CONTROL SYSTEM**

(57)　　A polarization control system (200) for a laser comprising an optical element (210) configured to interact with incident electromagnetic radiation (245). The polarization control system also comprises an actuator (220) configured to move the optical element to adjust a polarization of the electromagnetic radiation. The actuator is configured to rotate the optical element about a first axis (225) to adjust a polarization of the electromagnetic radiation. The actuator is configured to rotate the optical element about a second axis to adjust a diattenuation of the electromagnetic radiation.

FIG. 3

**Description**

FIELD

The present invention relates to a system and method of controlling polarization that are suitable for use with a laser. The present invention also relates to a radiation source and a lithographic system comprising the polarization control system. The present invention also relates to methods of generating radiation and projecting a patterned beam of radiation onto a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A laser source may be used to generate high-power electromagnetic radiation. The high-power electromagnetic radiation (e.g. an infra-red laser beam) may be used to generate a plasma. The plasma may emit electromagnetic radiation of a desired wavelength (e.g. extreme ultraviolet electromagnetic radiation). The emitted electromagnetic radiation may be supplied to a lithographic apparatus and used to pattern a substrate.

An example of equipment using a high-power laser beam is an Extreme Ultraviolet (EUV) lithographic system wherein EUV radiation is produced by a so-called laser-produced plasma (LPP) source. In the LPP source, a high-power laser, e.g., a CO2-laser, illuminates mass-limited targets, e.g., droplets of tin, one at a time. Each target is then converted into plasma that produces EUV radiation upon the plasma's free electrons recombining with the plasma's ions. The EUV radiation thus produced is used in a lithographic apparatus to image a pattern via projection optics onto a semiconductor wafer.

EUV LPP source of the type using a laser pre-pulse (PP) and a laser main pulse (MP). The PP is configured to condition the target for receipt of the MP, and the MP is configured to convert the conditioned target into plasma. The PP is produced by a PP seed laser, and the MP is produced by a MP seed laser. The PP and MP travel the same path through the power amplifiers and through the beam transport system towards a Final Focus Assembly (FFA). One of the functions of the FFA is create different paths for the PP and for the MP so as to be able to focus the PP and the MP at different focal points along the trajectory of a flying droplet of tin. The radiation of the PP and the radiation of the MP have slightly different wavelengths, and the different paths are created by means of dichroic mirrors.

Optical components, such as mirrors and windows, may be present in the beam path between laser source and the lithographic apparatus. Mirrors are typically used to determine the course of the beam path by means of changing the direction of the incident beam or to adjust the beam's wavefront. Windows are typically used to physically separate adjacent environments traversed by the beam path, e.g., environments having different gasses and/or held at different pressures. Polarization control is an important parameter to protect the PP and MP seed lasers from incoming (e.g. reflected) radiation.

It is an aim of the present invention to provide systems and methods that address one or more of the problems described above or at least provides a useful alternative.

SUMMARY

According to an aspect of the invention, there is provided a polarization control system for a laser comprising an optical element configured to interact with incident electromagnetic radiation and an actuator configured to move the optical element to adjust a polarization of the electromagnetic radiation. The actuator is configured to rotate the optical element about a first axis to adjust a polarization of the electromagnetic radiation. The actuator is configured to rotate the optical element about a second axis to adjust a diattenuation of the electromagnetic radiation.

The polarization control system advantageously reduces or removes the need for multiple bulky and/or expensive polarization control components of existing laser systems, thereby reducing the cost, size and complexity of existing laser systems. The polarization control system is much easier and faster to repair and/or replace, thereby reducing an inactive "downtime" of existing laser systems. The polarization control system advantageously withstands higher power electromagnetic radiation compared to known polarization control systems (e.g. a Soleil-Babinet compensator). The polarization control system advantageously allows smaller adjustments to be made to the polarization of electromagnetic radiation with greater precision compared to known polarization control systems. For example, the polarization control system may be capable of making polarization phase adjustments of about 1 degree or less. The polarization control system is advantageously more compact than known polarization control systems. The polarization control system may, for example, form part of an optical isolator.

The electromagnetic radiation may comprise infrared radiation. The electromagnetic radiation may comprise radiation having a wavelength of about 10.2 microns and/or about 10.6 microns.

The optical element may be configured to impart a phase retardation between an S polarization component and a P polarization component of the electromagnetic radiation. The actuator may be configured to move the optical element such that the phase retardation imparted by the optical element changes. The optical element and the actuator may therefore act together to control a polarization of the electromagnetic radiation.

Rotating the optical element about the first axis may change an angle of incidence between the electromagnetic radiation and the optical element. The first axis may be substantially perpendicular to a direction of propagation of the electromagnetic radiation. The angle of incidence may be less than 45°.

The second axis may be substantially perpendicular to the first axis. The second axis may be substantially parallel to a direction of propagation of the electromagnetic radiation.

The optical element may comprise an etalon.

The etalon may advantageously increase a precision with which polarization and diattenuation of the electromagnetic radiation may be controlled using the polarization control system. The etalon may be configured to filter the electromagnetic radiation at least partially based on a wavelength of the electromagnetic radiation. The etalon may be configured to produce Fabry-Perot interference effects. A length of an optical path of the electromagnetic radiation inside the etalon may be such that internal reflections of the electromagnetic radiation within the etalon get cancelled due to destructive interference.

The optical element may comprise a dielectric plate that is substantially isotropic and substantially homogeneous.

Using an etalon and/or a dielectric plate is different to known polarization control systems which comprise birefringent crystals that exhibit different indices of refraction along two perpendicular directions (which may be referred to as principle axis of the birefringent crystal). The optical element according to the invention may not comprise such principle/crystal axes, thereby improving an ease and flexibility of use of the polarization control system.

The optical element may comprise diamond.

Diamond advantageously can be made very thin to reduce unwanted loss of radiation whilst maintaining relative high mechanical strength, thereby reducing risk of becoming damaged/broken. Using diamond advantageously reduces or avoids the need for a cooling system due to reduced absorption of electromagnetic radiation.

The diamond may be formed from pure carbon under high pressures and high temperatures (HPHT diamond). The diamond may be formed from hydrocarbon gas by chemical vapor deposition (CVD diamond).

The optical element may comprise ZnSe.

Using ZnSe advantageously reduces a cost of the polarization control system compared to using diamond.

The optical element may be configured to transmit a majority of the incident electromagnetic radiation.

The optical element may be transmissive. This advantageously allows relatively small changes in polarization without disrupting an optical path of electromagnetic radiation. This in turn advantageously increases an ease with which the polarization control system may be integrated or retrofitted to existing laser systems. Through transmission, the polarization control system is advantageously able to change a difference in transmitted phase between an S polarization component and P polarization component of the electromagnetic radiation.

The optical element may be referred to as a membrane, i.e., an element that has a thickness that is much smaller than its length and/or width. The thickness of the optical element may be small enough such that it introduces only a negligible displacement, if any at all, between a direction of propagation of the incident electromagnetic radiation and a direction of propagation of the electromagnetic radiation exiting the optical element. That is, the presence of the optical element may not substantially affect an alignment of the electromagnetic radiation through a given system into which the polarization control system is incorporated.

The optical element may be uncoated.

Having an uncoated optical element advantageously reduces losses of electromagnetic radiation through the reduction of unwanted interactions (e.g. absorption and/or reflection) compared to known systems. This in turn advantageously reduces or avoids the need for a cooling system due to reduced absorption of electromagnetic radiation.

The optical element may comprise a layer of dielectric material.

Using a layer of dielectric material advantageously allows different adjustments to S and P components of polarization. That is, phase differences introduced to the S polarization component may differ from phase differences introduced to the P polarization component. Control of polarization is advantageously less restricted compared to known systems.

The dielectric material may comprise at least one of ThF4, BaF2 and Ge.

These materials have been found to work well and can offer different optical characteristics. For example, ThF4 has a low refractive index whereas Ge has a high refractive index. Introducing different dielectric layers advantageously allows further tailoring of the effects of the optical element for a given use.

The optical element may be polished.

Using a polished optical element advantageously reduces losses of electromagnetic radiation through the reduction of unwanted interactions (e.g. absorption and/or reflection) compared to known systems. This in turn advantageously reduces or avoids the need for a cooling system due to reduced absorption of electromagnetic radiation.

The optical element may have a thickness that is substantially equal to half a wavelength of the electromagnetic radiation multiplied by an integer.

This advantageously reduces losses of electromagnetic radiation through the reduction of unwanted interactions (e.g. absorption and/or reflection) compared to known systems. This in turn advantageously reduces or avoids the need for a cooling system due to reduced absorption of electromagnetic radiation. Losses of electromagnetic radiation through Fresnel reflections are advantageously reduced, providing increased transmission of electromagnetic radiation compared to known systems.

The optical element may be a first optical element configured to control the polarization of a first wavelength of radiation. The polarization control system may further comprise a second optical element configured to control the polarization of a second wavelength of radiation. The first and second optical elements may be arranged to interact with separate beams of electromagnetic radiation. The polarization control system may comprise a different optical element for each wavelength of radiation that is to be controlled by the polarization control system.

The integer may be greater than or equal to ten.

This advantageously increases a mechanical strength and/or rigidity of the optical element. This in turn reduces a risk of the optical element becoming damaged or breaking.

The optical element may have a thickness of between about 2 $\mu$m and about 1 mm The optical element may have a thickness of about 120 $\mu$m.

Using a thin optical element advantageously reduces unwanted adjustments (e.g. refraction/angular deviation) of electromagnetic radiation. Reducing a thickness of the optical element may advantageously reduce a disruption to an optical path of the incident electromagnetic radiation (e.g. from refraction caused by the optical element) and thereby increase an ease with which the polarization control system may be integrated/retrofitted to existing laser systems.

The polarization control system may comprise a structure configured to support the optical element. The structure may comprise a ring. The optical element may be bonded to the ring.

The optical element and the actuator may be located in a housing. The housing may comprise a beam dump.

The polarization control system may comprise a sensor configured to detect the electromagnetic radiation and produce detection information that is indicative of the detected electromagnetic radiation. The polarization control system may comprise a controller configured to receive the detection information and use the detection information to control the actuator.

The controller may be configured to cause the actuator to rotate the optical element about the first axis until the detection information indicates that the electromagnetic radiation is linearly polarized.

Rotation about first axis may clean up nearly linearized beams, so that the beams are again fully linearly polarized after transmission through the optical element.

The controller may be configured to cause the actuator to rotate the optical element about the second axis until the detection information indicates that a change in diattenuation introduced by the optical element has been at least partially compensated for.

Rotation about second axis may compensate residual diattenuation introduced by the optical element without introducing any further adjustment to polarization of the electromagnetic radiation. The optical element may be configured to redirect a portion of the electromagnetic radiation towards the sensor. The optical element may serve as a beam pick-off without ghosts, to perform high fidelity beam analysis on the picked-off electromagnetic radiation.

The optical element may be a first optical element. The actuator may be a first actuator. The polarization control system may comprise a second optical element configured to interact with the electromagnetic radiation. The polarization control system may comprise a second actuator configured to move the second optical element about the second axis to adjust the diattenuation of the electromagnetic radiation.

The second optical element may comprise an etalon. The second optical element may comprise a dielectric plate that is substantially isotropic and substantially homogeneous.

The second optical element may comprise diamond. The second optical element may comprise ZnSe. The second optical element may be configured to transmit a majority of the incident electromagnetic radiation. The second optical element may be uncoated. The second optical element may comprise a layer of dielectric material. The dielectric material may comprise at least one of ThF4, BaF2 and Ge. The second optical element may be polished. The second optical element may have a thickness that is substantially equal to half a wavelength of the electromagnetic radiation multiplied by an integer. The integer may be greater than or equal to ten. The polarization control system may comprise a second structure configured to support the second optical element. The second structure may comprise a ring. The second axis may be substantially perpendicular to the first axis. The second actuator may be configured to rotate the second optical element about the first axis and/or the second axis. The first and second axis may be substantially perpendicular to one another.

The second optical element may have a thickness of between about 50μm and about 1mm. The second optical element may have a thickness of about 450 μm.

Having a thicker second optical element may advantageously provide greater mechanical strength and allow for diameter of the second optical element to be larger than the first optical element to account for broader range of angles of incidence.

The first and second optical elements may be arranged such that an angle of incidence between the first optical element and the electromagnetic radiation is substantially equal to and opposite in sign to an angle of incidence between the second optical element and the electromagnetic radiation.

This advantageously reduces an angular deviation of the electromagnetic radiation beam path caused by an interaction (e.g. refraction) with the first and second optical elements. This in turn advantageously increases an ease with which the polarization control system may be integrated/retrofitted to existing optical systems (e.g. existing laser systems).

The second optical element and the second actuator may be located in a second housing. The second housing may comprise a second beam dump.

The controller may be configured to cause the first actuator to rotate the first optical element about the first axis until the detection information indicates that the electromagnetic radiation is linearly polarized. The controller may be configured to cause the second actuator to rotate the second optical element about the second axis until the detection information indicates that a change in diattenuation introduced by the first optical element has been at least partially compensated for.

Rotation about second axis may compensate residual diattenuation introduced by the optical element without introducing any further adjustment to polarization of the electromagnetic radiation. The first and/or second optical element may be configured to redirect a portion of the electromagnetic radiation towards the sensor. The first and/or second optical element may serve as a beam pick-off without ghosts, to perform high fidelity beam analysis on the picked-off electromagnetic radiation.

According to another aspect, there is also provided an optical isolation module comprising the polarization control system. The optical isolation may comprise fewer components than known optical isolation modules. The optical isolation module may advantageously be more compact than known optical isolation modules. When the optical isolation module of the present invention is comprised in any other system, for example a radiation source or a lithography apparatus, the optical isolation module of the present invention advantageously reduces the footprint of said elements making easier and more cost efficient any maintenance operations inside such systems.

According to another aspect, there is provided a radiation source comprising the polarization control system or the optical isolation module.

In a beam transport system of a radiation source, each beam bending mirror may corrupt the originally circular incident polarization of the electromagnetic radiation by adding a small phase shift, resulting in a reflected beam with a nearly circular polarization ellipse. The polarization control system provides a way to compensate for these small phase shifts and to restore the original polarization state.

The radiation source may be an EUV radiation source. The EUV radiation source may be configured to generate EUV radiation by exciting a target (e.g. a droplet of tin) and generating a plasma. The polarization of the electromagnetic radiation may be used (in conjunction with a polarization filter and a beam dump) to protect sensitive optical components of the radiation source from radiation that reflects back from the tin droplet towards the radiation source. Polarization control may therefore be an important feature of the radiation source.

According to another aspect there is provided a lithographic system comprising the polarization control system or the radiation source.

Known methods of adjusting polarization effects within a lithographic system involve taking the lithographic system offline for a significant amount of time (e.g. for eight hours or more), thereby reducing an overall throughput of the lithographic system, and replacing multiple expensive optical components (e.g. mirrors). The lithographic system comprising the polarization control system according to the invention advantageously enables fine polarization control whilst reducing or removing the need to deactivate the lithographic system and replace multiple expensive optical components (e.g. mirrors), thereby improving an overall throughput of the lithographic system and reducing a cost of maintaining lithographic system.

The polarization control system may advantageously reduce or remove the need to maintain one or more complex mirror polarization compensation systems and/or one or more complex mirror coating configurations that are used for different configurations of known lithographic systems. The polarization control system may advantageously enable a single mirror coating configuration to be used for different configurations of a lithographic system, thereby greatly simplifying operation and maintenance of the lithographic system compared to known lithographic systems.

The lithographic system may be an EUV lithographic system.

According to another aspect there is provided a method of controlling a polarization of electromagnetic radiation comprising using an optical element to interact with the electromagnetic radiation and moving the optical element to adjust the polarization of the electromagnetic radiation. Moving the optical element comprises rotating the optical element about a first axis to adjust a polarization of the electromagnetic radiation, and rotating the optical element about a second axis to adjust a diattenuation of the electromagnetic radiation.

The method may comprise using the polarization control system.

According to another aspect there is provided a method of generating radiation comprising using the radiation source.

According to another aspect there is provided a method comprising projecting a patterned beam of radiation onto a substrate, wherein the method comprises using the lithographic system.

According to another aspect there is provided a computer program comprising computer readable instructions configured to cause a computer to carry out the methods discussed above.

According to another aspect there is provided a computer readable medium carrying the computer program.

BRIEF DESCRIPTION OF THE DRAWINGS

Embodiments of the invention will now be described, by way of example only, with reference to the accompanying schematic drawings, in which:

- Fig. 1 schematically depicts a lithographic system comprising a lithographic apparatus and a radiation source;
- Fig. 2 schematically depicts a seed laser module;
- Fig. 3 schematically depicts a polarization control system being used to control an outgoing laser beam;
- Fig. 4 schematically depicts the polarization control system of Fig. 3 being used to control an incoming laser beam;
- Fig. 5 shows a graph of a change in polarization of a laser beam caused by the polarization control system of Fig. 3 or Fig. 4;
- Fig. 6A shows a graph of a change in polarization components caused by a first polarization control system, Fig. 6B shows a graph of a change in polarization components caused by a second polarization control system, and Fig. 6C shows a magnified section of the graph of Fig. 6B;
- Fig. 7A shows a graph of a change in polarization components caused by a third polarization control system, Fig. 7B shows a graph of a change in polarization components caused by a fourth polarization control system, and Fig. 7C shows a graph of a change in polarization components caused by a fifth polarization control system;
- Fig. 8 schematically depicts a polarization control system comprising first and second optical elements and first and second actuators;
- Fig. 9A shows a graph of a change in phase caused by the first optical element of Fig. 8, and Fig. 9B shows a graph of a change in diattenuation caused by the first optical element of Fig. 8;
- Fig. 10A shows a graph of a change of radiation losses for different arrangements of the second optical element of Fig. 8, and Fig. 10B shows a graph of a change of diattenuation for different arrangements of the second optical element of Fig. 8;
- Fig. 11 shows a graph of a crossing point at which a change in phase caused by the second optical element of Fig. 8 is zero and a change in diattenuation caused by the second optical element of Fig. 8 is unitary; and,
- Fig. 12 shows a graph of contours of equal radiation losses superimposed onto the graph of Fig. 11.

DETAILED DESCRIPTION

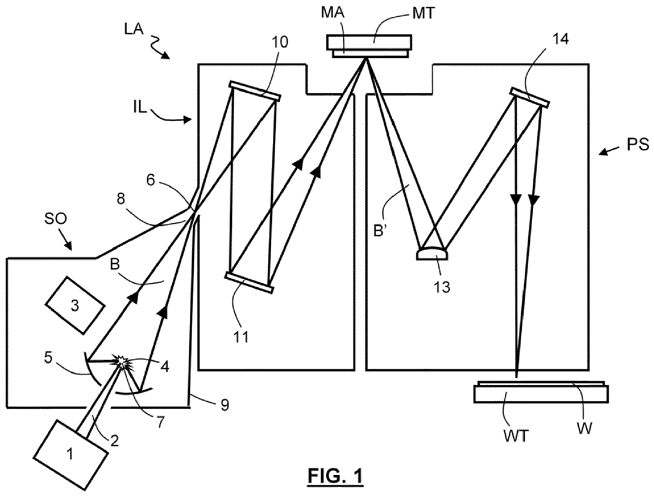

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

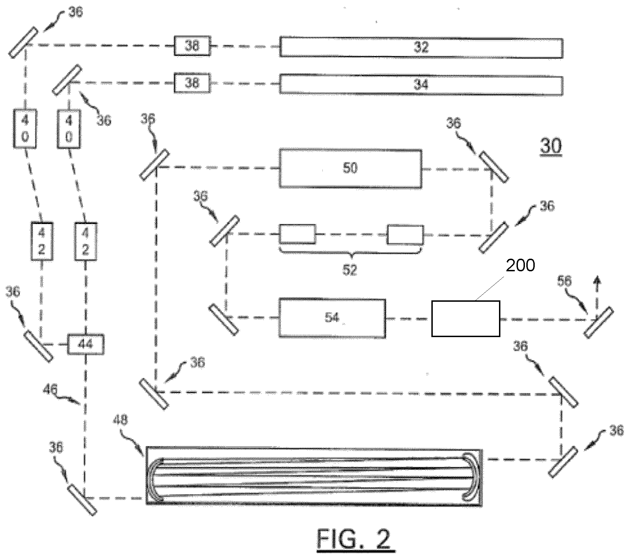

Fig. 2 shows a simplified schematic view of one embodiment of a seed laser module 30 that may be used as part of the laser system 1 in the LPP EUV source SO of Fig. 1. The seed laser module 30 is shown as having a folded arrangement rather than arranging the components in a straight line. In practice, such an arrangement is typical in order to limit the size of the module. To achieve this, the beams produced by the laser pulses of pre-pulse (PP) seed laser 32 and main pulse (MP) seed laser 34 are directed onto desired beam paths by a plurality of optical components 36. Depending upon the particular configuration desired, optical components 36 may include such elements as lenses, filters, prisms, mirrors or any other element which may be used to direct the beam in a desired direction.

A beam from a specific one of seed lasers 32, 34 is first passed through an electro-optic modulator 38 (EOM). The EOMs 38 are used with the seed lasers 32, 34 as pulse shaping units to trim the pulses generated by the seed lasers 32, 34 to pulses having shorter duration and faster fall-time. A shorter pulse duration and relatively fast fall-time may increase EUV output and light source efficiency because of a short interaction time between the pulse and a target, and because unneeded and thus discarded portions of the pulse do not deplete amplifier gain. While two separate pulse shaping units (EOMs 38) are shown, alternatively a common pulse shaping unit may be used to trim both PP and MP from the PP seed laser 32 and MP seed laser 34, respectively.

A beam from a specific one of the seed lasers 32, 34 is then passed through acousto-optic modulators (AOMs) 40, 42. The AOMs 40, 42 act as switches or shutters, which operate to divert at least some reflections of the laser pulses from the target material from reaching the seed lasers 32, 34. Seed lasers 32, 34 typically contain sensitive optics, and the AOMs 40 and 42 reduce damage to the seed lasers' sensitive optics from reflected portions of radiation. In the embodiment shown here, the beams from the seed lasers 32, 34 each pass through two AOMs. In some other embodiments, the beams from seed lasers 32, 34 may each be passed through only a single AOM on each path. After passing through the AOMs 40, 42 the two beams are combined by a beam combiner 44. Since the pulses from the seed lasers 32, 34 are generated at different times, this combining implies that the two temporally separated beams are placed on a common beam path 46 for further processing and use.

After being placed on the common beam path 46, the beam from one of the seed lasers 32, 34 (again, there will only be one active at a time in this example) passes through a beam delay unit 48. Next, the beam is directed through a pre-amplifier 50 and then through a beam expander 52. Following this, the beam passes through a polarizer 54, e.g., a thin film polarizer, and is then directed onward by optical device 56, which again is a device which directs the beam to the next stage in the LPP EUV system and may perform other functions as well. From optical device 56, the beam typically passes to one or more optical amplifiers (power amplifiers) and other components.

Accordingly, the beam from the PP seed laser 32 and the beam from the MP seed laser 34 are put on a common path in seed laser module 30. The PP is configured to condition the tin droplet for receipt of the MP. As indicated above with reference to Fig. 1, the tin droplet moves along a trajectory from the fuel emitter 3 to the plasma formation region 4. Typically, the PP will cause the tin droplet to expand, and will also impart a lateral velocity to the expanding tin droplet. As the PP and the MP occur one after the other, the PP beam and the MP beam may need to be focused at different locations. For this reason, the PP beam and the MP beam may need to be separated again. As mentioned above, one of the functions of the Final Focus Assembly (FFA) (not shown) is to create different paths for the PP and for the MP so as to be able to focus the PP and the MP at different focal points along the trajectory of a flying droplet of tin. This separation of the PP beam and the MP beam may be accomplished using, for example, dichroic mirrors.

Polarization control is an important parameter to protect components of the laser system 1, such as the PP seed laser 32 and/or the MP seed laser 34, from returning (e.g. reflected) radiation. For example, radiation may reflect from the fuel (e.g. a droplet of tin) at the plasma formation region 4 and travel back towards the laser source 1. Without sufficient polarization control, the high-power seed modules 32, 34 may not be protected against reflected radiation, which in turn may negatively affect the function of seed laser modules 32, 34. For example, the reflected radiation may damage the seed laser modules 34, 32, which may result in power fluctuations, reduced efficiency, increased times spent on repairs and/or maintenance, etc. All of these negative effects may result in a reduced throughput of a lithographic system configured to receive EUV radiation from the EUV LPP radiation source.

A known method of compensating for damage caused by reflected radiation having unwanted changes in polarization involves replacing one or more optical components (e.g. mirrors) of the laser system 1. The known method is expensive and can take a considerable amount of time (e.g. about two days) due to the required realignment of optical components in the beam path. This in turn significantly reduces a throughput of a lithographic system configured to receive radiation from the laser system. Another known method of compensating for unwanted polarization changes involves maintaining a specific set of mirrors that each contribute a specific polarization phase retardation effect. This known method is also very expensive and involves complex maintenance of different mirror coating configurations for each individual lithographic system.

Interactions between the electromagnetic radiation and the optical components 36 may introduce unwanted changes to the polarization of the electromagnetic radiation. For example, each time the electromagnetic radiation is reflected by a mirror 36 a polarization of the electromagnetic radiation may change. A thickness of and/or number of layers of and/or type of coating on each mirror 36 may affect the unwanted change in polarization introduced to the electromagnetic radiation. The laser system may comprise many mirrors, which in turn will introduce many unwanted changes to the polarization of the electromagnetic radiation. Reflected radiation having an unwanted polarization may not be filtered by optical isolators within the laser system, and may therefore reach and damage sensitive optical components such as the PP seed laser 32 and the MP seed laser 34.

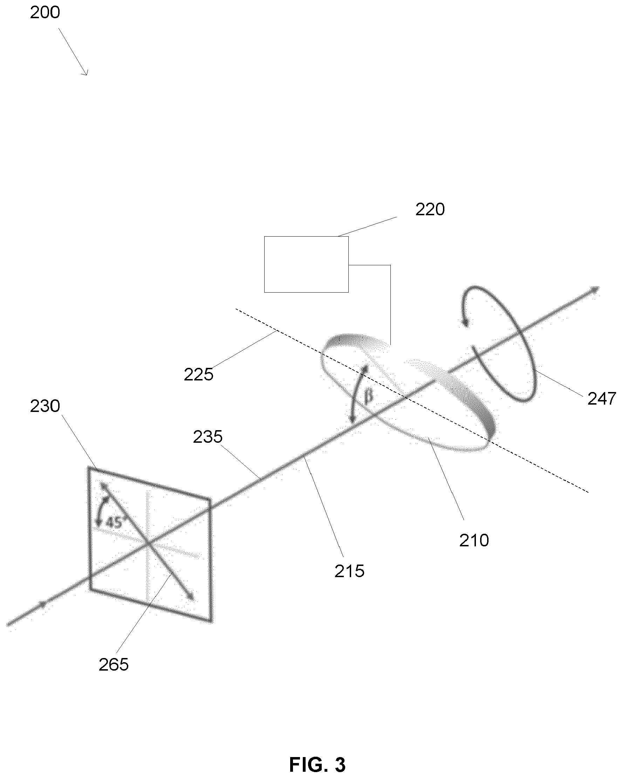

Fig. 3 schematically depicts a polarization control system 200 being used to control an outgoing laser beam 215. The polarization control system 200 comprises an optical element 210 configured to interact with incident electromagnetic radiation 215. The electromagnetic radiation 215 may comprise infrared radiation, e.g. radiation having a wavelength of about 10.2 $\mu$m and/or radiation having a wavelength of about 10.6 $\mu$m. The optical element 210 may comprise an etalon. The etalon may comprise a dielectric plate that is substantially isotropic and substantially homogenous. The etalon may be configured to produce Fabry-Perot interference effects. The optical element 210 may comprise diamond. The diamond may be made very thin (e.g. using chemical vapor deposition to form the optical element 210) which reduces unwanted losses of electromagnetic radiation (e.g. reduced absorption) whilst maintaining a relatively high mechanical strength and durability. Alternatively the optical element 210 may comprise zinc selenide, which may be less expensive to obtain and manufacture than diamond. The optical element may have a thickness of about 2 $\mu$m or more. The optical element may have a thickness of about 1 mm or less. For example, the optical element may have a thickness of about 120 $\mu$m. Decreasing a thickness of the optical element 210 may increase a spacing of Fabry-Perot resonances of the optical element 210. This may increase an ease with which a desired polarization is achieved using the optical element 210 by requiring less precise movements of the optical element 210.

The optical element 210 may have a thickness that is substantially equal to half a wavelength of the electromagnetic radiation 215 multiplied by an integer. This may advantageously reduce unwanted losses of electromagnetic radiation 215 through the reduction of unwanted interactions (e.g. absorption and/or reflection) compared to known polarization control systems. This reduce unwanted losses of electromagnetic radiation 215 through Fresnel reflections are reduced. In general, the greater the value of the integer, the more mechanical strength and durability the optical element 210 may have. For example, when the electromagnetic radiation has a wavelength of about 10.6 $\mu$m, the optical element 210 may have a thickness of the integer multiplied by about 2.230 $\mu$m. For example, the integer may be ten or more. The optical element 210 may be thought of as an absentee layer. That is, because the optical element 210 has a relatively small thickness, the optical element 210 may not angularly deviate the transmitted laser beam. Thus, the optical alignment and/or propagation direction of the laser beam is not affected by the optical element 210. This may also advantageously reduces or removes entirely a need to provide cooling to the optical element 210 because there is practically no heating due to practically no laser power absorption.

The polarization and diattenuation of incident electromagnetic radiation may be controlled with improved precision using the polarization control system 200. The polarization control system 200 may be configured to control the polarization and diattenuation of a beam comprising two or more different wavelengths of electromagnetic radiation. For example, referring again to Fig. 2, the polarization control system 200 may be located within the common beam path 46 of the PP and MP. The PP and MP may comprise different wavelengths of radiation. The polarization control system 200 may be configured such that the polarization and diattenuation of the PP and the MP (and/or reflected portions thereof) may be controlled by a single polarization control system whilst maintaining a desired minimum transmission of the PP and MP wavelengths (e.g. at least 95% transmission of the PP and the MP). For example, a thickness of the optical element 210 of the polarization control system 200 may be selected in at least partial dependence on the wavelengths of radiation that are to be controlled using the polarization control system (e.g. the wavelengths of the PP and the MP) and/or a desired minimum transmission of the polarization control system and/or a range of angles of incidence that the one or more optical elements of the polarization control system are configured to operate within.

The optical element 210 is transmissive and is configured to transmit a majority of the incident electromagnetic radiation 215. For example, the optical element 210 may transmit about 100% of the electromagnetic radiation 215 at normal incidence. The optical element 210 preferably induces negligible changes to a propagation direction of the electromagnetic radiation 215. The optical element 210 may not act as a wave plate, which may change the polarization of the electromagnetic radiation 215 significantly. The optical element 210 may instead be configured to impart relatively small changes to the polarization of the electromagnetic radiation 215. For example, the optical element 210 may be configured to "clean up" a nearly linearized laser beam such that the laser beam becomes fully linearly polarized after transmission through the optical element 210. Alternatively, the optical element 210 may be configured to "clean up" a nearly circularly polarized laser beam such that the laser beam becomes fully circularly polarized after transmission through the optical element 210. In general, the optical element 210 is configured to impart a phase retardation between an S polarization component and a P polarization component of the electromagnetic radiation 215. In the example of Fig. 3, the electromagnetic radiation 215 is linearly polarized 265 at 45° relative to the plane of incidence 230. That is, the linear polarization 265 of the electromagnetic radiation 215 may be split in equal parts to an S polarization component and a P polarization component. The optical element 210 receives the linearly polarized 265 electromagnetic radiation 215 (e.g. a laser beam) and introduces a phase difference between the S polarization component and the P polarization component of the electromagnetic radiation 215. The optical element 210 thereby changes the polarization of the electromagnetic radiation 215 from linearly polarized 265 to slightly elliptically polarized 247. The plane of incidence 230 shown in Fig. 3 is merely present to demonstrate the polarization of the electromagnetic radiation 215 and does not represent a physical object. The optical element 210 may be uncoated, which advantageously reduces unwanted losses of electromagnetic radiation 215 (e.g. via unwanted absorption). The optical element 210 may be polished to advantageously reduce unwanted losses of electromagnetic radiation 215 (e.g. via unwanted absorption). The polarization control system 200 may comprise a structure (not shown) configured to support the optical element 210. The structure may, for example, comprise a ring that the optical element 210 is bonded to. The structure may facilitate mechanical mounting of the optical element 210.

The polarization control system 200 further comprises an actuator 220 configured to move the optical element 210 to adjust a polarization of the electromagnetic radiation 215. The actuator 220 may be configured to rotate the optical element 210 about a first axis 225 to adjust the polarization of the electromagnetic radiation 215. Rotating the optical element 210 about the first axis 225 may change an angle of incidence β between the electromagnetic radiation 215 and the optical element 210. The first axis 225 may be substantially perpendicular to a direction of propagation of the electromagnetic radiation 215. The angle of incidence β may, for example, be less than 45°.

The actuator 220 may be configured to rotate the optical element 210 about a second axis 235 to adjust a diattenuation of the electromagnetic radiation 215. The second axis 235 may be substantially perpendicular to the first axis 225. The second axis 235 may be substantially parallel to a direction of propagation of the electromagnetic radiation 215.

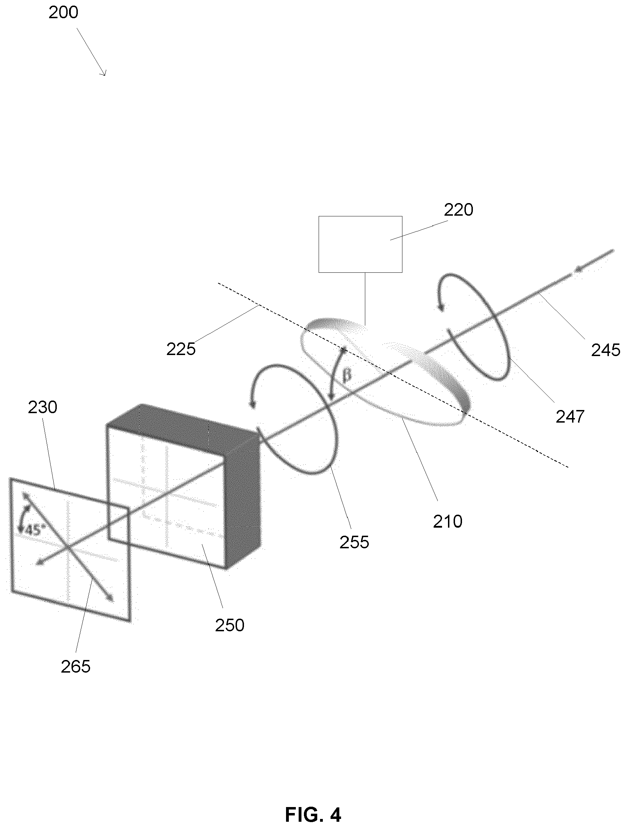

Fig. 4 schematically depicts the polarization control system 200 of Fig. 3 being used to control an incoming laser beam 245. In the example of Fig. 4, the incoming electromagnetic radiation 245 is elliptically polarized 247 when approaching the optical element 210. The optical element 210 introduces a phase difference between the S polarization component and the P polarization component of the elliptically polarized 247 electromagnetic radiation 245. The optical element 210 thereby changes the polarization of the electromagnetic radiation 245 from elliptically polarized 247 to circularly polarized 255. In the example of Fig. 4, the polarization control system 200 forms part of an optical isolator. A quarter wave plate 250 is located downstream of the optical element 210. The quarter wave plate 250 receives the circularly polarized electromagnetic radiation 255 and adjusts the polarization to provide linearly polarized electromagnetic radiation 265 (as is shown on the plane of incidence 230). An optical isolator may receive the linearly polarized electromagnetic radiation and prevent the linearly polarized electromagnetic radiation from reaching, and potentially damaging, sensitive optical components of the radiation source.

The following passages provide a mathematical description of how a substantially isotropic and substantially homogeneous dielectric plate may be used as a compensator to influence an elliptical state of polarization of a monochromatic plane wave of electromagnetic radiation. Known methods of influencing a phase difference between an S polarization component and a P polarization component involves using plane parallel plates of uniaxial birefringent crystals placed perpendicular to the beam axis. This makes it necessary to consider the so-called "slow" and "fast" axes of the birefringent crystal plate and to properly orient these axes with respect to the optical axis. Furthermore, such birefringent crystals may not be suitable for use with non-visible wavelengths of radiation, e.g. infrared radiation (e.g. radiation having a wavelength of about 10.6 $\mu$m), and/or radiation having a power of more than a few Watts. The birefringent crystals may not transmit a sufficient amount of incident radiation and may require significant changes to be made to the optical path of the radiation before the birefringent crystal can be introduced to a laser source or a lithographic system.

One method of introducing controlled optical retardation involves placing a dielectric plate under oblique incidence in the laser beam. If the angle of incidence is too large then unwanted Fresnel reflection losses may occur. However, if the dielectric plate is configured to compensate for a few degrees of polarization phase retardation then the angle of incidence will be relatively small and hence also the Fresnel reflection losses will be correspondingly small. The laser beam may initially be completely linearly polarized. When the laser beam reflects from a mirror (e.g. a metallic mirror) the polarization state of the reflected laser beam may be changed from linear to slightly elliptic due to a phase shift upon reflection. This phase shift may be due to fabrication tolerances on the coatings with which the mirror is provided. More subsequent reflections of the laser beam downstream the beam propagation path can increase the ellipticity of the polarization of the laser beam further. A known method of compensating for these phase shifts involves using a variable retardation plate, which may be referred to as a Soleil-Babinet compensator. However, a disadvantage of using a Soleil-Babinet compensator is that the Soleil-Babinet compensator is expensive and cannot withstand high powers of radiation (e.g. the powers of radiation involved in an LPP EUV radiation source).

By using a substantially homogeneous and substantially isotropic dielectric plate to compensate for the phase shifts, minute phase corrections can be applied to the laser beam with great precision. This ability to correct for small phase changes may be particularly advantageous in a radiation source such as the LPP EUV radiation source previously described, e.g. in an optical isolation module of a $CO_2$ drive laser. The following discussion involves two wavelengths of electromagnetic radiation: PP and MP. The dielectric plate may be configured to impart polarization adjustments on both wavelengths simultaneously. That is, a polarization control system comprising a single optical element may be used to impart fine phase control or retardations on two different wavelengths simultaneously. As previously discussed, the dielectric plate may comprise diamond and may be formed using chemical vapor deposition. The diamond plate can be made extremely thin (e.g. about 50 $\mu$m) whilst maintaining a high mechanical strength and a high refractive index (e.g. a refractive index of about two or more).

Electromagnetic radiation having a wavelength $\lambda$ and its associated wavenumber k:

$$k = \frac{2\pi}{\lambda}$$

The electromagnetic radiation may be incident on the optical element at an angle of incidence $\vartheta_i$. A parameter $\beta$ may be defined as follows:

$$\beta = k\sqrt{n^2 - \sin^2 \vartheta_i}$$

Where $\beta$ is the normal component of the transmitted wave vector and $n$ is a refractive index of the optical element. Two further parameters, $K_s$ and $K_P$, may be defined as follows:

$$2K_s = \frac{\cos\vartheta_i}{\sqrt{n^2 - \sin^2\vartheta_i}} + \frac{\sqrt{n^2 - \sin^2\vartheta_i}}{\cos\vartheta_i}$$

$$2K_p = \frac{n^2\cos\vartheta_i}{\sqrt{n^2 - \sin^2\vartheta_i}} + \frac{\sqrt{n^2 - \sin^2\vartheta_i}}{n^2\cos\vartheta_i}$$

The optical element has a thickness d. A retardation $\Delta$ between the P polarization component and the S polarization component may be defined as follows:

$$\tan\Delta = \frac{(K_s - K_p)\tan\beta d}{1 + K_s K_p \tan^2\beta d}$$

The thickness of the optical element may be selected as any desired value. By selecting a thickness of an integer multiple of half of the wavelength of the electromagnetic radiation, then substantially no Fresnel reflection losses will occur at a relatively small angle of incidence (e.g. from about 0 degrees to about 5 degrees).

As is the case with the polarization control system of Fig. 3, the polarization control system of Fig. 4 may be configured to control the polarization and diattenuation of a beam comprising two or more different wavelengths of electromagnetic radiation. For example, a thickness of the optical element of the polarization control system may be selected in at least partial dependence on the wavelengths of radiation that are to be controlled using the polarization control system (e.g. the wavelengths of the PP and the MP) and/or a desired minimum transmission of the polarization control system and/or a range of angles of incidence that the one or more optical elements of the polarization control system are configured to operate within.

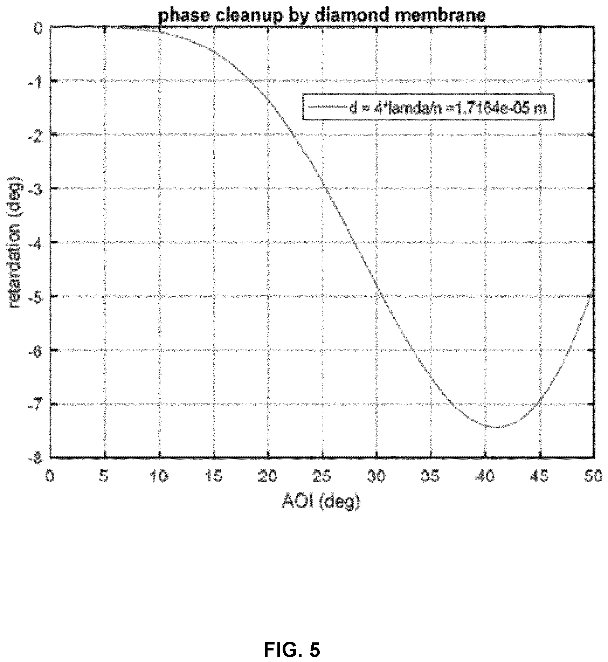

Fig. 5 shows a graph of a change in polarization of a laser beam caused by the polarization control system of Fig. 3 and Fig. 4. In the example of Fig. 5, the wavelength of the PP is about 10.2 $\mu$m, the refractive index of the optical element is about 2.377, and the thickness of the optical element d is equal to four times the wavelength divided by the refractive index. Fig. 5 shows that by rotating the optical element and thereby varying an angle of incidence (AOI) from 0° to 30°, the phase retardation applied to the electromagnetic radiation may be set anywhere between 0° and about -5°. By rotating the optical element over 90° azimuthally about the propagation axis of the electromagnetic radiation, the S and P polarization components are interchanged, and positive values of phase retardation may be achieved. For a main pulse MP having a wavelength of about 10.6 $\mu$m, the refractive index of diamond is virtually identical to that at a pre-pulse PP wavelength of about 10.2 $\mu$m. This is due to the relatively small difference in wavelength between the MP and the PP, along with the relatively small change in refractive index of the optical element for the different wavelengths.

Known wave plates are typically constructed from birefringent crystals that exhibit different indices of refraction along two perpendicular directions, which may be referred to as the principal axes. If the principal axes coincide with the axes of a reference coordinate frame (e.g. a laboratory frame), a Jones matrix of a wave plate with a phase retardation $\Delta$ may be as follows:

$$M = \begin{bmatrix} 1 & 0 \\ 0 & e^{i\Delta} \end{bmatrix}$$

The optical element of the present invention may not comprise crystal axes. However, the Jones matrix M remains the same as that for a wave plate. For example, an incident Jones vector of a nearly linearly polarized laser beam having an azimuth angle of 45° may be as follows:

$$E_{in} = \begin{bmatrix} 1 \\ \exp i\varphi \end{bmatrix}$$

where $\vartheta$ is a small angle, e.g. between -5° and 5°. An output Jones vector may be as follows:

$$E_{out} = M \,.E_{in} = C \begin{bmatrix} 1 \\ 1 \end{bmatrix}$$

where C is a constant complex number, which may be discarded for polarization state analysis. The phase retardation to be applied by the optical element to compensate for the incident phase retardation may be given by the following equation:

$$\Delta = -\varphi$$

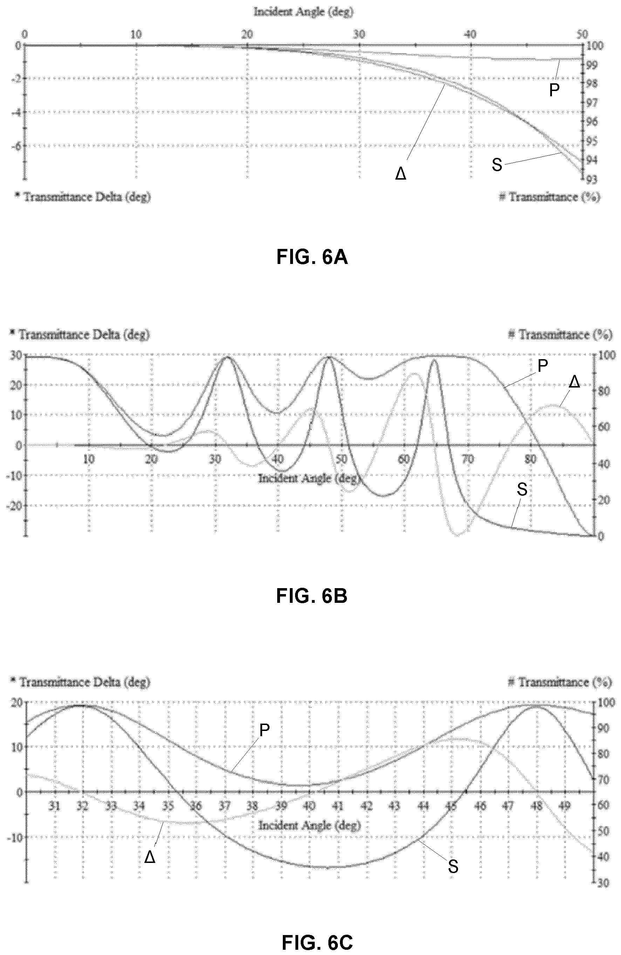

Fig. 6A shows a graph of a change in polarization components caused by a first polarization control system. The graph shows changes in a phase shift $\Delta$ and a transmittance of the S and P polarization components of incident electromagnetic radiation across a range of angles of incidence (0° to 50°). In the example of Fig. 6A, the electromagnetic radiation has a wavelength of 10.2 $\mu$m and the optical element has a thickness of half of the wavelength of the electromagnetic radiation. In the example of Fig. 6A, as the optical element is rotated (thereby changing the angle of incidence), only negative phase shifts are applied to the electromagnetic radiation by the optical element. However, as discussed above, it is possible to convert these negative phase shifts in positive phase shifts by rotating the optical element by 90° abound the optical axis. This rotation results in the S and P polarization components being interchanged. As such, the phase shift will be positive rather than negative. The polarization control system is therefore capable of imparting positive and negative phase retardations to the electromagnetic radiation.

Fig. 6B shows a graph of a change in polarization components caused by a second polarization control system. The graph shows changes in a phase shift $\Delta$ and a transmittance of the S and P polarization components of incident electromagnetic radiation across a range of angles of incidence (0° to 90°). In the example of Fig. 6B, the electromagnetic radiation has a wavelength of 10.2 $\mu$m and the optical element has a thickness of twenty times the wavelength of the electromagnetic radiation. In the example of Fig. 6B, as the optical element is rotated (thereby changing the angle of incidence), both positive and negative polarization phase shifts are applied to the electromagnetic radiation by the optical element.

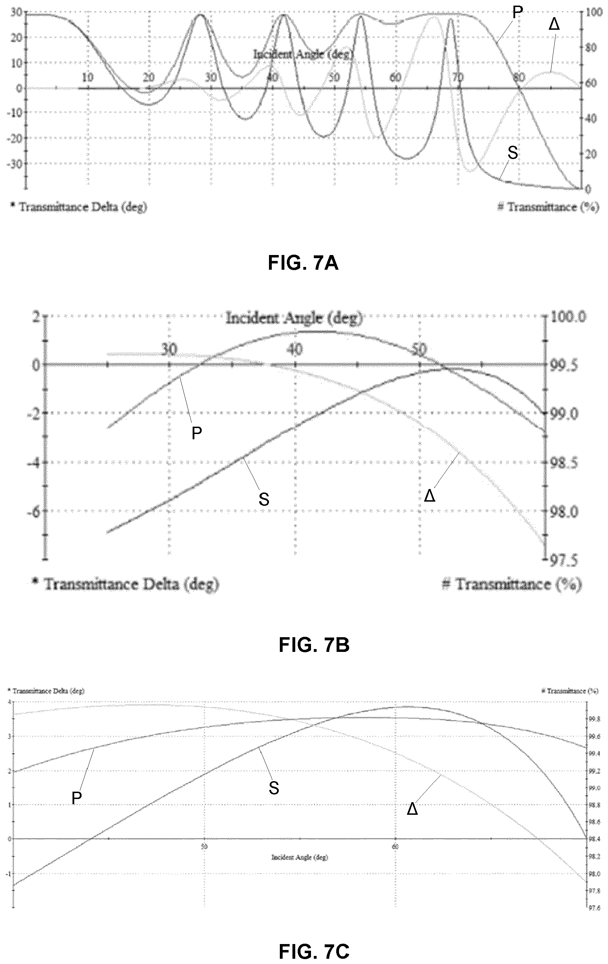

Fig. 6C shows a magnified section of the graph of Fig. 6B (i.e. at angles of incidence between 30° and 50°). As can be seen, the maximum transmittance of the S and P polarization components are substantially equal, and that at these specific angles of incidence (i.e. about 32° and about 48°), the phase shift $\Delta$ is substantially zero. This is the case for a bare dielectric surface. This relationship may be altered by providing the bare dielectric surface with a layer of dielectric material which has a relatively low refractive index (e.g. within the inclusive range of about 1.3 and about 1.6) for infrared radiation or a relatively high refractive index (e.g. about 2 or more) for infrared radiation. For example, the layer of dielectric material may comprise ThF4 which has a refractive index of about 1.6 for infrared radiation. As another example, the layer of dielectric material may comprise Ge which has a refractive index of about 4.0 for infrared radiation. As a further example, the layer of dielectric material may comprise ZnSe which has a refractive index of about 2.4 for infrared radiation. The addition of a layer of dielectric material to the optical element is discussed in greater detail below in connection with Figs. 7B and 7C.

Fig. 7A shows a graph of a change in polarization components caused by a third polarization control system. The graph shows changes in a phase shift $\Delta$ and a transmittance of the S and P polarization components of incident electromagnetic radiation across a range of angles of incidence (0° to 90°). In the example of Fig. 7A, the electromagnetic radiation has a wavelength of 10.2 $\mu$m and the optical element has a thickness of twenty five times the wavelength of the electromagnetic radiation. In the example of Fig. 7A, as the optical element is rotated (thereby changing the angle of incidence), both positive and negative phase shifts are applied to the electromagnetic radiation by the optical element.

The optical element may comprise a dielectric layer (not shown). The dielectric layer may add an extra degree of freedom to the polarization adjustment made by the optical element. An entrance or exit surface of the optical element may be provided with, for example, a thin film of ThF4, BaF2 or Ge.

Fig. 7B shows a graph of a change in polarization components caused by a fourth polarization control system The graph shows changes in a phase shift Δ and a transmittance of the S and P polarization components of incident electromagnetic radiation across a range of angles of incidence (25° to 60°). In the example of Fig. 7B, the electromagnetic radiation has a wavelength of 10.2 μm and the optical element has a thickness of half of the wavelength of the electromagnetic radiation, and a 700 nm dielectric layer of ThF4 has been added to a surface of the optical element. In the example of Fig. 7B, as the optical element is rotated (thereby changing the angle of incidence), both positive and negative phase shifts are applied to the electromagnetic radiation by the optical element.

Fig. 7C shows a graph of a change in polarization components caused by a fifth polarization control system. The graph shows changes in a phase shift Δ and a transmittance of the S and P polarization components of incident electromagnetic radiation across a range of angles of incidence (40° to 70°). In the example of Fig. 7C, the electromagnetic radiation has a wavelength of 10.2 μm, the optical element has a thickness of half of the wavelength of the electromagnetic radiation, and two 25 nm dielectric layers of Ge have been added to the entrance and exit surfaces of the optical element. On comparing Figs. 7A-7C, it can be seen that adding one or more dielectric layers to the optical element and adjusting their thickness provides an extra degree of freedom to controlling the phase of incident electromagnetic radiation. This enhanced degree of polarization control can be very fine, as the examples demonstrate.

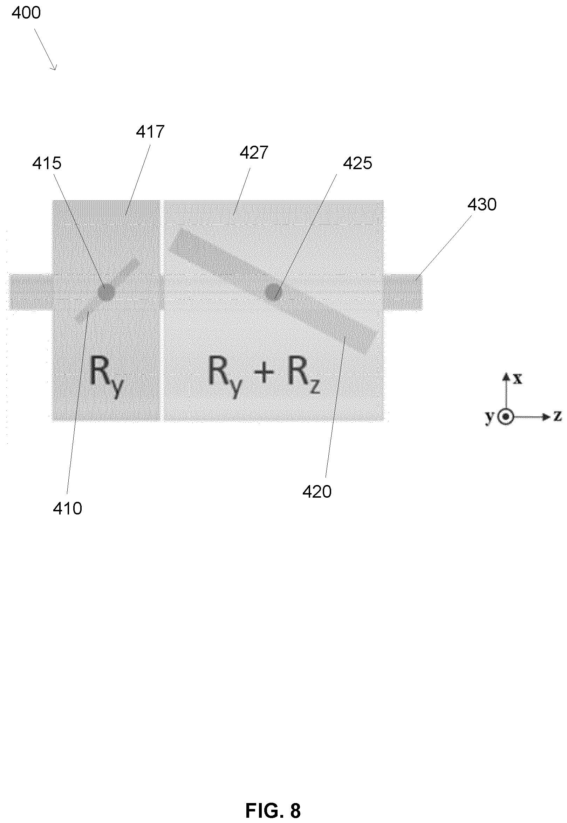

Fig. 8 schematically depicts a polarization control system 400 comprising first and second optical elements 410, 420 and first and second actuators 415, 425. The first and second optical elements 410, 420 are configured to interact with the electromagnetic radiation 430. The first actuator 415 is configured to move the first optical element 410 to adjust a polarization of the electromagnetic radiation 430. The first actuator 415 may be configured to rotate the first optical element 410 about a first axis y. The second actuator 425 may be configured to move the second optical element 420 to adjust a diattenuation of the electromagnetic radiation. The second actuator 425 may be configured to rotate the second optical element 425 about the first axis y and/or a second axis z. The second axis z may be substantially perpendicular to the first axis y.

The first optical element 410 may be substantially the same as the optical element 210 shown and described in connection with Fig. 3. The second optical element 420 may comprise an etalon. The second optical element 420 may comprise a dielectric plate that is substantially isotropic and substantially homogeneous. The second optical element 420 may comprise diamond. The second optical element 420 may comprise ZnSe. The second optical element 420 may be configured to transmit a majority of the incident electromagnetic radiation 430. The second optical element 420 may be uncoated. The second optical element 420 may comprise a layer of dielectric material. The dielectric material may comprise at least one of ThF4, BaF2 and Ge. The second optical element 420 may be polished. The second optical element 420 may have a thickness that is greater than the first optical element 410. The greater thickness of the second optical element 420 may allow the diameter of the second optical element 420 to be increased compared to the first optical element 410 to accommodate electromagnetic radiation having a larger angle of incidence. The second optical element 420 may be sized so as to allow the second optical element 420 to be arranged at or proximate to Brewster's angle with respect to incident electromagnetic radiation. The second optical element 420 may have a thickness of about 50 μm or more. A lower limit to the thickness of the second optical element 420 may at least partially be determined by a desired mechanical rigidity of the second optical element 420 and/or a cross-sectional size of the beam of incident electromagnetic radiation. The second optical element 420 may have a thickness of about 1 mm or less. An upper limit to the thickness of the second optical element 420 may at least partially be determined by a maximum acceptable refraction of incident electromagnetic radiation caused by the second optical element 420 and/or a loss (e.g. absorption and/or reflection) of electromagnetic radiation interacting with the second optical element 420 and/or a cross-sectional size of the beam of incident electromagnetic radiation. The second optical element 420 may have a thickness of about 450 μm. The polarization control system 400 may comprise a second structure (not shown) configured to support the second optical element 420. The second structure may comprises a ring. The second optical element 420 may be thought of as an imperfect Brewster window operated at an angle of incidence near the Brewster angle.

The second optical element 420 may be configured to substantially compensate for diattenuation caused by the electromagnetic radiation 430 traversing the first optical element 410 without introducing additional phase retardation of the electromagnetic radiation 430. For example, the second optical element 420 may introduce a phase retardation of about 0.5° or less. Transmission of the electromagnetic radiation 430 through the first and second optical elements 410, 420 may be about 95% or more.

The first optical element 410 and the first actuator 415 are located in a first housing 417. The first housing 417 may comprise a first beam dump (not shown). The second optical element 420 and the second actuator 425 are located in a second housing 427. The second housing 427 may comprise a second beam dump (not shown).

The polarization control system 400 may be configured to compensate for relatively small phase shifts and diattenuation in a nearly linearly polarized beam. In this way, the incoming beam may be transformed by the first optical element 410 into a linearly polarized beam with equal S and P polarization components. That is, a differential phase shift of the electromagnetic radiation may be substantially equal to zero and a diattenuation of the electromagnetic radiation may be substantially equal to one.

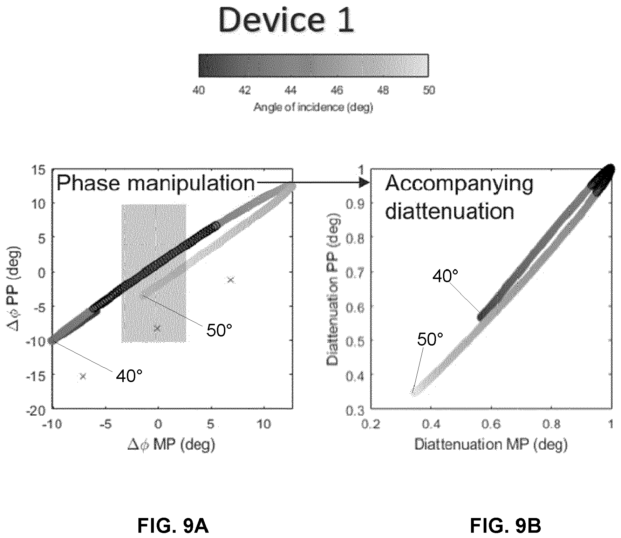

Fig. 9A shows a graph of a change in phase caused by the first optical element of Fig. 8. Fig. 9B shows a graph of a change in diattenuation caused by the first optical element of Fig. 8. In the example of Figs. 9A and 9B, the polarization control system is configured to control the polarization of the MP and the PP of the laser source (as discussed in relation to Fig. 2). The first optical element 410 of the polarization control system is rotated across a range of angles such that the angle of incidence for incident electromagnetic radiation gradually changes from a starting value of 40° to an end value of 50°. As can be seen, whilst the first optical element 410 may be used to adjust a polarization of electromagnetic radiation, the first optical element 410 also introduces some unwanted diattenuation of the electromagnetic radiation. The second optical element 420 may be configured to compensate for the unwanted diattenuation introduced by the first optical element 410.

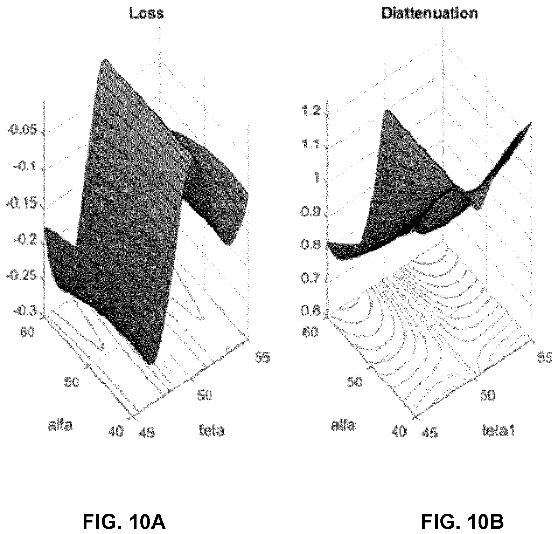

Fig. 10A shows a graph of a change of radiation losses for different arrangements of the second optical element 420 of Fig. 8. Fig. 10B shows a graph of a change of diattenuation for different arrangements of the second optical element of Fig. 8. The graphs plot the loss and the diattenuation over the range 45° to 55° degrees for rotation of the second optical element 420 about the first axis y (i.e. theta) and 40° to 60° for rotation of the second optical element 420 about the second axis z (i.e. alpha). By determining where the phase is substantially equal to zero and the diattenuation is substantially equal to one, a crossing point of both curves is found when theta is about 48.67° and alpha is about 49.80°.

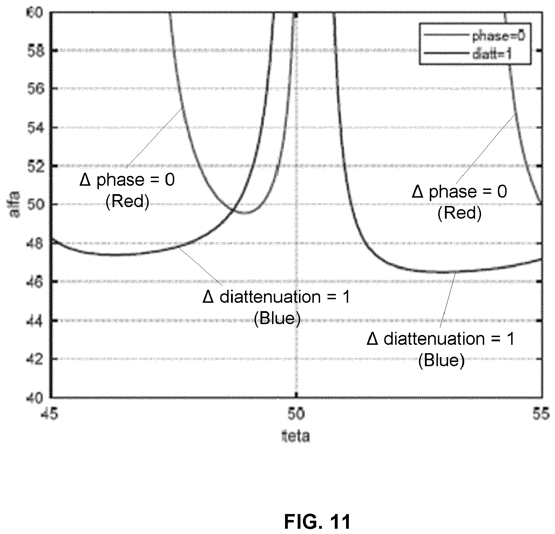

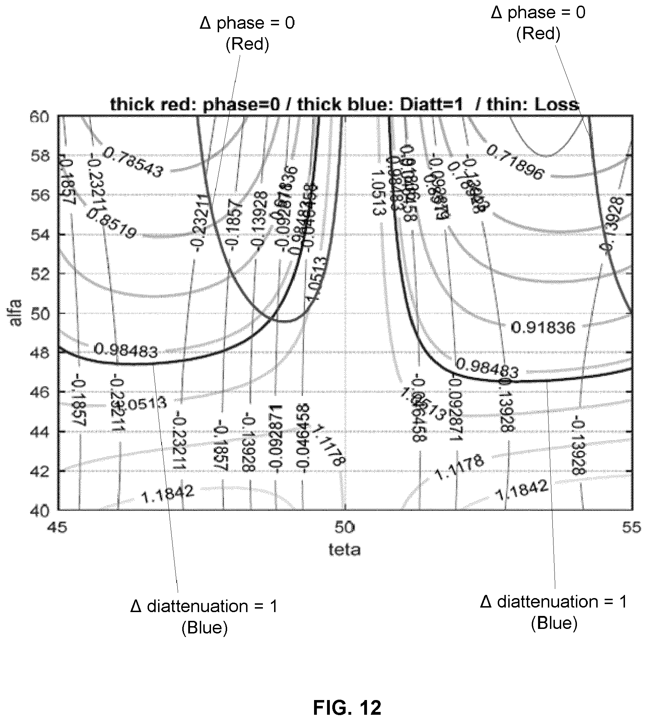

Fig. 11 shows a graph of a crossing point at which a change in phase caused by the second optical element of Fig. 8 is zero and a change in diattenuation caused by the second optical element of Fig. 8 is unitary. Fig. 12 shows a graph of contours of equal radiation losses superimposed onto the graph of Fig. 11. The amount of radiation loss is indicated by the numerical values within each of the contours. By adjusting the angle of incidence and azimuthal rotation of the first and second optical elements 410, 420 the polarization control system 400 can control a polarization and/or a diattenuation of the electromagnetic radiation 430 with acceptable optical losses (e.g. transmission of 90% or more of incident electromagnetic radiation, or transmission of about 95% or more of incident electromagnetic radiation). A range across which the polarization control system 400 may control the polarization and/or diattenuation of the electromagnetic radiation 430 may be at least partially determined by a selected maximum allowable loss of electromagnetic radiation.

The following passages provide a mathematical description of polarization control using an etalon. First the transmission formulas of a single etalon under a certain angle of incidence are considered. The Fresnel reflection and transmission coefficients at a single dielectric interface, for the S and P polarization components. For the transition from the incident medium to the etalon these are $r_p$, $r_s$, $t_p$, $t_s$. For the transition from the etalon to the emergent medium, these are $r_p'$, $r_s'$, $t_p'$, $t_s'$. The incident and emerging medium have a refractive index $n_1$, and the etalon has a refractive index $n_2$.

$$t_s = \frac{2n_1 \cos \vartheta_i}{n_1 \cos \vartheta_i + n_2 \cos \vartheta_t}$$

$$t_p = \frac{2n_1 \cos \vartheta_i}{n_2 \cos \vartheta_i + n_1 \cos \vartheta_t}$$

$$r_p = \frac{n_2 \cos \vartheta_i - n_1 \cos \vartheta_t}{n_2 \cos \vartheta_i + n_1 \cos \vartheta_t}$$

$$r_s = \frac{n_1 \cos \vartheta_i - n_2 \cos \vartheta_t}{n_1 \cos \vartheta_i + n_2 \cos \vartheta_t}$$

Primed coefficients may be obtained by interchanging $n_1$ and $n_2$. Assuming that $n_1=1$ and $n_2=n$, auxiliary coefficients may be defined as follows:

$$r_p^2 = R_p$$

$$r_s^2 = R_s$$

$$t_p t'_p = T_p$$

$$t_s t'_s = T_s$$

The phase shift per reflection in the etalon may be as follows:

$$\delta = \frac{4\pi}{\lambda} nh \cos \vartheta_2$$

The law of Snellius is as follows:

$$n_1 \sin \vartheta_1 = n_2 \sin \vartheta_2$$

All of these parameters may be applied to Airy formulas for transmission coefficients ts and tp of the etalon , which may be given by the following relationship:

$$\mathbf{t}_k = \frac{T_k}{1 - R_k e^{i\delta}} \qquad k = s, p$$

A Jones matrix for the etalon may have the same form as the Jones matrix for a dielectric plate:

$$\mathbf{J} = \begin{bmatrix} \mathbf{t}_p & 0 \\ 0 & \mathbf{t}_s \end{bmatrix}$$

The transmission coefficients may be dependent on the angle of incidence $\theta_1$ in the Fresnel formulas.
The second operation that may be considered is a rotation of the etalon around the optical axis, according to an azimuthal angle $\alpha$ . The matrix R(a) needed to represent an azimuthally turned polarization component over the angle $\alpha$ may be as follows:

$$R(\alpha) = \begin{bmatrix} \cos \alpha & \sin \alpha \\ -\sin \alpha & \cos \alpha \end{bmatrix}$$

After the azimuthal rotation, the Jones matrix J may take the following form:

$$\mathbf{R}(-\alpha) \cdot \mathbf{J} \cdot \mathbf{R}(\alpha) = \begin{bmatrix} \mathbf{t}_p \cos^2 \alpha + \mathbf{t}_s \sin^2 \alpha & \mathbf{t}_p \sin \alpha \cos \alpha - \mathbf{t}_s \sin \alpha \cos \alpha \\ \mathbf{t}_p \sin \alpha \cos \alpha - \mathbf{t}_s \sin \alpha \cos \alpha & \mathbf{t}_s \cos^2 \alpha + \mathbf{t}_p \sin^2 \alpha \end{bmatrix} = \begin{bmatrix} A & B \\ B & C \end{bmatrix}$$

where A, B and C are in general complex numbers.
A mathematical description is provided above for the example of an incoming vector defined by the following matrix:

$$\begin{bmatrix} E_{in} \\ E_{in} e^{i\delta} \end{bmatrix}$$

Which is nearly linearly polarized. The etalon may compensate the phase shift in order to arrive at full linear polarization by setting the proper angle of incidence of the etalon with respect to the incident electromagnetic radiation.

However, as previously discussed, an unwanted diattenuation is introduced to the electromagnetic radiation. The introduced diattenuation may not be under control because there may not be any free parameters left in the Airy formulas to set in order to achieve a desired diattenuation.

However, some compensation of the diattenuation may be achieved when considering the azimuthal angle (i.e. alpha). The angle of incidence is denoted $\theta_1$ and the angle $\alpha$ determines the rotation of the etalon around the optical axis. The incident polarization vector may be given by the following matrix:

$$\begin{bmatrix} E_{in1} \\ E_{in2}\exp i\Delta \end{bmatrix}$$

where the amplitudes $E_{in1}$ and $E_{in2}$ are positive real numbers, and, for making small adjustments to the polarization of the electromagnetic radiation as described above, may be approximately equal to each other. The emerging polarization vector may be linear and may be specified by the following relationship:

$$E_{out1} = E_{out2}$$

where the amplitudes are real, positive numbers. A transfer may be calculated in accordance with the following relationship:

$$E_{in} \rightarrow etalon(\vartheta_1, \alpha) \rightarrow E_{out}$$

where $\theta_1$ and $\alpha$ are variable, in order to arrive at the correct phase and diattenuation. The representing Jones matrices may be multiplied in the inverse order as follows:

$$\begin{bmatrix} E_{out1} \\ E_{out2} \end{bmatrix} = \mathbf{R}^{-1}(\alpha) \begin{bmatrix} \mathbf{t}_p(\vartheta_1) & 0 \\ 0 & \mathbf{t}_s(\vartheta_1) \end{bmatrix} \mathbf{R}(\alpha) \begin{bmatrix} E_{in1} \\ E_{in2}e^{i\Delta} \end{bmatrix}$$

$$= \begin{bmatrix} A(\alpha,\vartheta_1) & B(\alpha,\vartheta_1) \\ B(\alpha,\vartheta_1) & C(\alpha,\vartheta_1) \end{bmatrix} \begin{bmatrix} E_{in1} \\ E_{in2}e^{i\Delta} \end{bmatrix}$$

Or, in full:

$$E_{out1} = AE_{in1} + BE_{in2}\,e^{i\Delta}$$

$$E_{out2} = BE_{in1} + CE_{in2}\,e^{i\Delta}$$

Due to their complexity, these equations may not be inverted. That is, $\alpha$ and $\theta_1$ may not be calculated as a function of the other etalon parameters. A graphical solution may be needed. To compare the two vectors, we will consider their length as follows:

$$L_{in}^2 = \left| E_{in1} \right|^2 + \left| E_{in2} \right|^2$$

$$L_{out}^2 = \left| E_{out1} \right|^2 + \left| E_{out2} \right|^2$$

The diattenuation D may be defined as follows:

$$D = \left| \frac{E_{out1}}{E_{out2}} \right|^2$$

The phase of the outgoing vector. Ideally, the three following conditions may be satisfied simultaneously:

$$Lout = Lin$$

$$D = 1$$

$$Phase = 0$$

This may be achieved by generating a graphical representation of the following equations:

$$E_{out1} = AE_{in1} + BE_{in2} \, e^{i\Delta}$$

$$E_{out2} = BE_{in1} + CE_{in2} \, e^{i\Delta}$$

and by plotting $E_{out1}$ and $E_{out2}$ and phase($E_{out1}$)-phase($E_{out2}$) as a function of $\alpha$ and $\theta_1$ as follows:

$$\frac{L_{out}^2 - L_{in}^2}{L_{in}^2} = F\{\vartheta_1, \alpha\}$$

$$phase(E_{out1}) - phase(E_{out2}) = G\{\vartheta_1, \alpha\}$$

Ideally, to reach ideal linear polarization without loss of radiation energy, the length of the outgoing vector may be equal to the length of the incoming vector, and the amplitude ratio F may be equal to one. The phase difference G may be equal to zero. A plot of F and G may be three-dimensional. Because of the complex shape of the generated surfaces, it may be difficult to visually find the points of intersection between the surfaces F=0 and G=1. A simpler option of finding the points of intersection may involve plotting the contours in the $\theta_{1-}$ $\alpha$ plane, in particular the contours for F=0 and G=1. The eventual intersection points deliver the graphical values of incident and azimuthal angle.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1.  A polarization control system for a laser comprising:

    an optical element configured to interact with incident electromagnetic radiation; and,
    an actuator configured to move the optical element to adjust a polarization of the electromagnetic radiation,
    wherein the actuator is configured to rotate the optical element about a first axis to adjust a polarization of the electromagnetic radiation, and
    wherein the actuator is configured to rotate the optical element about a second axis to adjust a diattenuation of the electromagnetic radiation.

2.  The polarization control system of claim 1, wherein the optical element and the actuator are located in a housing and wherein the housing comprises a beam dump.

3.  The polarization control system of any preceding claim, comprising:

    a sensor configured to detect the electromagnetic radiation and produce detection information that is indicative of the detected electromagnetic radiation; and,
    a controller configured to receive the detection information and use the detection information to control the actuator.

4.  The polarization control system of claim 3, wherein the controller is configured to cause the actuator to rotate the optical element about the first axis until the detection information indicates that the electromagnetic radiation is linearly polarized.

5.  The polarization control system of claim 4, wherein the controller is configured to cause the actuator to rotate the optical element about the second axis until the detection information indicates that a change in diattenuation introduced by the optical element has been at least partially compensated for.

6.  The polarization control system of any of claims 1 or 2, wherein the optical element is a first optical element and wherein the actuator is a first actuator, the polarization control system comprising:

    a second optical element configured to interact with the electromagnetic radiation; and,
    a second actuator configured to move the second optical element about the second axis to adjust the diattenuation of the electromagnetic radiation.

7.  The polarization control system of claim 6, wherein the second optical element has a thickness of between about 50$\mu$m and about 1mm.

8.  The polarization control system of claim 6 or claim 7, wherein the first and second optical elements are arranged such that an angle of incidence between the first optical element and the electromagnetic radiation is substantially equal to and opposite in sign to an angle of incidence between the second optical element and the electromagnetic radiation.

9.  The polarization control system of any of claims 6 to 8, wherein the second optical element and the second actuator are located in a second housing, and wherein the second housing comprises a second beam dump.

10. The polarization control system of any of claims 6 to 9 when dependent from claim 3, wherein the controller is configured to:

    cause the first actuator to rotate the first optical element about the first axis until the detection information indicates that the electromagnetic radiation is linearly polarized; and,

cause the second actuator to rotate the second optical element about the second axis until the detection information indicates that a change in diattenuation introduced by the first optical element has been at least partially compensated for.

11. The polarization control system of any preceding claim, wherein the optical element comprises an etalon.

12. The polarization control system of any preceding claim, wherein the optical element comprises a dielectric plate that is substantially isotropic and substantially homogeneous.

13. The polarization control system of any preceding claim, wherein the optical element comprises diamond.

14. The polarization control system of any preceding claim, wherein the optical element comprises ZnSe.

15. The polarization control system of any preceding claim, wherein the optical element is configured to transmit a majority of the incident electromagnetic radiation.

16. The polarization control system of any preceding claim, wherein the optical element is uncoated.

17. The polarization control system of any preceding claim, wherein the optical element comprises a layer of dielectric material.

18. The polarization control system of claim 18, wherein the dielectric material comprises at least one of ThF4, BaF2 and Ge.

19. The polarization control system of any preceding claim, wherein the optical element is polished.

20. The polarization control system of any preceding claim, wherein the optical element has a thickness that is substantially equal to half a wavelength of the electromagnetic radiation multiplied by an integer.

21. The polarization control system of claim 20, wherein the integer is greater than or equal to ten.

22. The polarization control system of any preceding claim, wherein the optical element has a thickness of between about 2 $\mu$m and about 1 mm.

23. The polarization control system of any preceding claim, comprising a structure configured to support the optical element.

24. The polarization control system of claim 23, wherein the structure comprises a ring.

25. An optical isolation module comprising the polarization control system of any of claims 1 to 24.

26. A radiation source comprising the polarization control system of any of claims 1 to 24 or the optical isolation module of claim 25.

27. A lithographic system comprising the polarization control system of any of claims 1 to 24, or the radiation source of claim 26.

28. A method of controlling a polarization of electromagnetic radiation comprising:

using an optical element to interact with the electromagnetic radiation; and,
moving the optical element to adjust the polarization of the electromagnetic radiation,
wherein the moving comprises:

rotating the optical element about a first axis to adjust a polarization of the electromagnetic radiation, and
rotating the optical element about a second axis to adjust a diattenuation of the electromagnetic radiation.

29. The method of claim 28, comprising using the polarization control system of any of claims 1 to 24.

**30.** A method of generating radiation comprising using the radiation source of claim 26.

**31.** A method comprising projecting a patterned beam of radiation onto a substrate, wherein the method comprises using the lithographic system of claim 27.

**32.** A computer program comprising computer readable instructions configured to cause a computer to carry out a method according to any of claims 28 to 31.

**33.** A computer readable medium carrying a computer program according to claim 32.

**FIG. 1**

FIG. 2

200

220

225

230

235

247

β

215

210

265

45°

**FIG. 3**

**FIG. 4**

**FIG. 5**

**FIG. 6A**

**FIG. 6B**

**FIG. 6C**

**FIG. 7A**

**FIG. 7B**

**FIG. 7C**

**FIG. 8**

FIG. 9A               FIG. 9B

Loss

Diattenuation

FIG. 10A

FIG. 10B

**FIG. 11**

FIG. 12

Europäisches
Patentamt

European
Patent Office

Office européen
des brevets

# EUROPEAN SEARCH REPORT

Application Number

EP 20 17 4769

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 6 075 235 A (CHUN CORNELL SEU LUN [US])<br>13 June 2000 (2000-06-13)<br>* abstract *<br>* figure 3 *<br>* column 1, lines 11,12 *<br>* column 5, lines 13-43 *<br>----- | 1-9,<br>11-15<br>10 | INV.<br>G03F7/20<br>G02B27/28 |
| X<br>A | JP H07 236095 A (KONISHIROKU PHOTO IND)<br>5 September 1995 (1995-09-05)<br>* abstract *<br>* figure 1 *<br>* paragraphs [0001], [0008] - [0010] *<br>----- | 1,11,12,<br>15<br>2-10,13,<br>14 | |
| A | WO 2019/158215 A1 (TRUMPF LASERSYSTEMS<br>SEMICONDUCTOR MFG GMBH [DE])<br>22 August 2019 (2019-08-22)<br>* abstract *<br>* figure 7 *<br>* claim 14 *<br>----- | 1-15 | |

TECHNICAL FIELDS
SEARCHED     (IPC)

G03F
G02B

The present search report has been drawn up for all claims

| Place of search | Date of completion of the search | Examiner |
|---|---|---|
| Munich | 24 February 2021 | Andersen, Ole |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 20 17 4769

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2021

| Patent document cited in search report | | Publication date | Patent family member(s) | | Publication date |
|---|---|---|---|---|---|
| US 6075235 | A | 13-06-2000 | NONE | | |
| JP H07236095 | A | 05-09-1995 | NONE | | |
| WO 2019158215 | A1 | 22-08-2019 | US | 2020379281 A1 | 03-12-2020 |
| | | | WO | 2019158215 A1 | 22-08-2019 |

EPO FORM P0459

For more details about this annex : see Official Journal of the European Patent Office, No. 12/82